Europäisches Patentamt

European Patent Office

Office européen des brevets

(11) Publication number: **0 065 795**
**B1**

## (12) EUROPEAN PATENT SPECIFICATION

(45) Date of publication of patent specification: **25.07.84**

(21) Application number: **82200520.3**

(22) Date of filing: **03.05.82**

(51) Int. Cl.³: **H 03 K 13/05**

(54) **Digital-to-analog converter for bipolar signals.**

(30) Priority: **07.05.81 NL 8102226**

(43) Date of publication of application:
**01.12.82 Bulletin 82/48**

(45) Publication of the grant of the patent:
**25.07.84 Bulletin 84/30**

(84) Designated Contracting States:
**AT DE FR GB IT NL SE**

(56) References cited:
**DE - A - 2 020 170**
**FR - A - 2 357 110**
**US - A - 3 995 266**
**US - A - 4 016 555**
**US - A - 4 250 558**

(73) Proprietor: **N.V. Philips' Gloeilampenfabrieken**
**Groenewoudseweg 1**
**NL-5621 BA Eindhoven (NL)**

(72) Inventor: **van de Plassche, Rudy Johan**
**INT. OCTROOIBUREAU B.V. Prof. Holstlaan 6**
**NL-5656 AA Eindhoven (NL)**
Inventor: **Dijkmans, Eise Carel**
**INT. OCTROOIBUREAU B.V. Prof. Holstlaan 6**
**NL-5656 AA Eindhoven (NL)**

(74) Representative: **Groenenberg, Johannes Hendrik**
**et al,**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a digital-to-analog converter for bipolar signals, in which the value of the most significant bit changing when the signal passes through the zero level, which converter comprises $n$ inputs for $n$ bits to be converted, at least $n$ switches which are coupled to the $n$ inputs and which switch analog reference quantities which together determine the analog value which is available on an output of the converter, and means for reducing the influence of switching transients on the analog value when the bits change in value.

Such a digital-to-analog converter is known from the article by F. Maddens and M. Quintin, entitled: "Digital to analog converter for low level PCM signals" in IBM Technical Disclosure Bulletin, Vol. 17, No. 5, October 1974, pages 1383 and 1384. The article gives a solution to the problem of the poor signal-to-noise ratio occurring with small signal amplitudes due to the repeated passage of the digital input signal through the value which corresponds to the zero level of the signal which it represents. All bits are switched at these times and change in digital value. If, as is customary, a switch which switches an analog quantity, is controlled by each bit, an equal number of analog quantities can be switched on and off. Different switching times and delays give rise to switching transients on the analog output signal. The sum of said transients constitutes an additional signal, which is added to the output signal each time it passes through zero. For example, in the case of sinewave signals, such as audio signals, this contribution results in increased distortion and a reduction of the signal-to-noise ratio. In the known digital-to-analog converter the said problem is solved by means of logic circuits arranged between the bit inputs, so that for the $n$ bit inputs n + m switching lines are obtained which each actuate a switching transistor for switching on and off a current which, *via* a resistor network, produces an analog voltage which no longer has the stepped binary waveform. Thus, it is avoided that switching $n$ bits also results in $n$ analog quantities being switched. The digital-to-analog converter which is described is a 3-bit converter. For more bits the number of digital circuits becomes uneconomically large, whilst moreover a special resistor network must be used.

The invention aims to improve the distortion behaviour and signal-to-noise ratio using a smaller number of elements, regardless of the number of bits and using a binary digital-to-analog converter section.

To achieve this use is made of the recognition that both the distortion behaviour and the signal-to-noise ratio will improve if whilst the spurious signals, in the present case switching transients remain unchanged, the value of the bipolar signal at which these occur is increased. To this end a digital-to-analog converter of the type mentioned in the opening paragraph is characterized in that the said means comprise a generator which generates a digital number and which is arranged between the said inputs and the switches and thereby provides an internal digital offset.

Said digital offset results in a specific digital number being added to or subtracted from the digital signal which is applied. This means that the centre of the digital input signal range where all $n$ bits change in value, now corresponds to a non zero amplitude of the applied signal. The value of the digital offset may for example be 1 to 30%, so that the digital number to be generated may be a "1" in the fourth bit position $= 1/16 = 6\%$, the fifth bit position $= 1/32 = 3\%$ or the sixth bit position $= 1/64 = 1.5\%$ reckoned from the most significant bit.

Since the digital-to-analog converter in accordance with the invention thus has an internal digital offset, the output analog signal will have a corresponding offset. If this is not desirable an analog source of opposite sign may be arranged at the output, so that an applied signal of zero amplitude also results in an analog zero signal.

An embodiment of the digital-to-analog converter is therefore characterized in that an analog compensation source is coupled to the output in order to compensate for the effect on the analog value of the digital offset.

A further embodiment is characterized in that the generator comprises an adder, of which a number of inputs are connected to an equal number of said $n$ inputs corresponding to the most significant bits, of which an equal number of further inputs are connected to points carrying potentials which together correspond to the digital number, and of which an equal number of outputs are coupled to control inputs of those switches which switch the most significant reference quantities.

In this respect it is advantageous that the digital-to-analog converter can be built by means of standard elements. The only addition to a conventional converter may be constituted by one or two elements known and available as "4-bit-full adder".

The invention will now be described in more detail with reference to the drawing, whilst moreover an advantageous embodiment will be described.

Figure 1 illustrates steps in accordance with the invention,

Figure 2 illustrates the improvement obtainable and

Figure 3 shows a detailed circuit diagram.

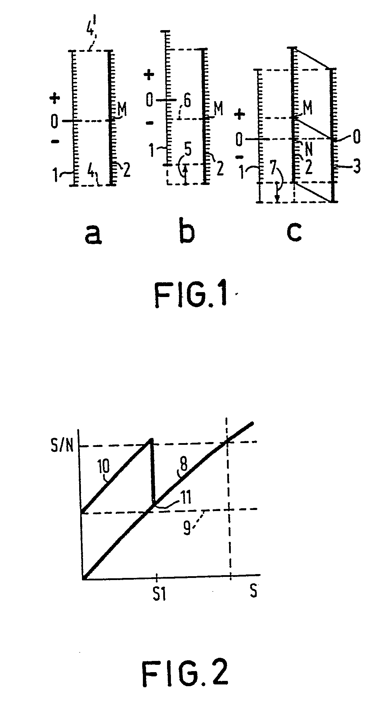

In Figure 1 the invention is illustrated in three diagrams a, b and c. Column 1 in Figure 1a represents the range of the bipolar digital input signal in analog form. The zero level of the bipolar signal is situated in the centre of the scale and thus corresponds to the value 1 for the most significant bit and the value 0 for all the other bits. Passage through said zero level consequently means that all $n$ bits will change, namely the most significant bit becomes 0 and all the other n-1 bits become 1. Column 2 in Figure 1a represents the analog scale of the output signal of the digital-to-analog converter. The broken lines 4 and 4' indicate that the "digital" input scale 1 corresponds to the analog output scale 2.

In Figure 1b a step in accordance with the invention has been applied. To the digital value of column 1 as applied to the input digital number 5 is added. The combination 1 + 5 is converted from digital to analog form as is represented by column 2. The centre of column 2, designated M, again represents the point at which all bits change. However, this point is reached for a "negative" value of the input signal, as represented by the broken line 6 between column 1 and column 2. By a suitable choice this value can be optimized depending on the application and on the building elements used.

In Figure 1c a digital number 7 is subtracted from the digital input signal in accordance with column 1. Now the centre M is reached for a "positive" value of the input signal. Moreover, column 3 indicates that the digital offset 7 can be compensated for by means of an oppositely directed analog offset. This may be of importance when the analog output signal is d.c. coupled to a further signal processing device to be connected to the output. Point M of the scale may then be the original zero point, which is shifted to point 0 or column 3. Columns 1 and 3 of Figure 1c also show that a part of the range corresponding to the digital number 7 is no longer available for driving. As already stated, this number may be only a few percent of the range, which for example in the case of audio applications hardly affects the maximum drive.

Figure 2 shows schematically the improvement in signal-to-noise ratio that can be obtained. The amplitude of a sinewave signal S which is represented by a digital input signal to a digital-to-analog converter is plotted along the horizontal logarithmic axis. The signal-to-noise ratio at the output of the converter is plotted along the vertical logarithmic axis. Each time the sinewave signal passes through zero the largest switching transient occur and contribute to the noise. As is indicated by the line 8 in the absence of a step according to the invention the signal-to-noise ratio will increase from zero as the signal S increases. However, when a step according to the invention is employed the signal starts at small amplitudes with a much smaller noise level because the largest contribution is absent and there is a level 9 below which the signal-to-noise ratio does not decrease. In the case of larger signals the ratio becomes increasingly more favourable, as is presented by the line 10. However, if for the amplitude is reached at which all $n$ bits

change (signals $S_1$) the signal-to-noise ratio decreases to point 11 and for larger signals the line 8 is followed again.

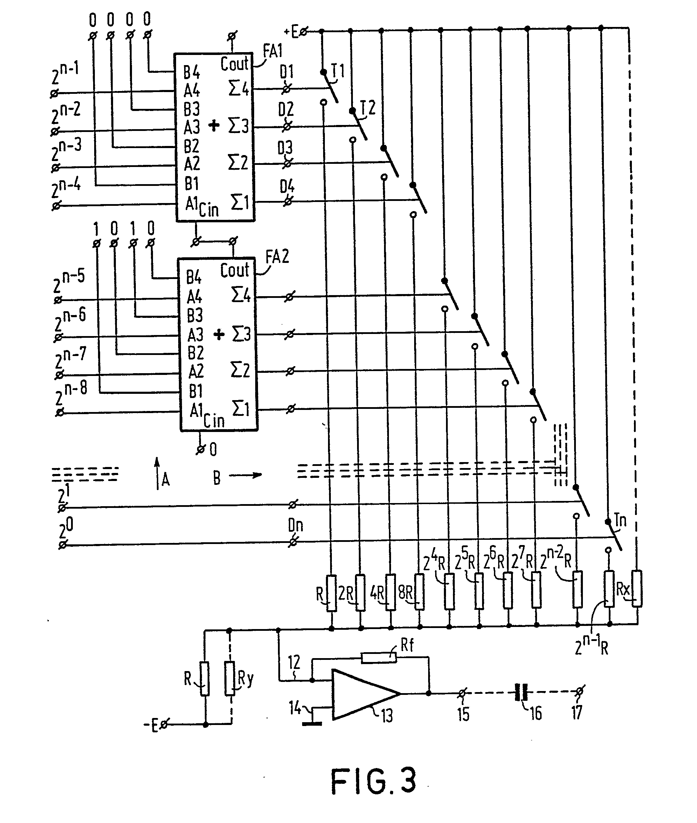

Figure 3 shows the circuit diagram of a digital-to-analog converter in accordance with the invention. It comprises a converter section B, which is for example as described in the article "D/A conversion" by H. Schmid in "Electronic Design" 22. October 1968, page 52, Fig. 4 and page 53, Fig. 6, and a generator A for the digital offset. The section B comprises the digital inputs $D_1$ to $D_n$, which control the switches $T_1$ to $T_n$. When the switches T are closed, binary scaled resistors R are connected between the summing point 12 of an amplifier 13 and a reference supply +E. The amplifier 13 receives negative feedback from the output 15 to the input 12 *via* a resistor $R_f$, whilst the input 14 is connected to earth. The output voltage of the amplifier is adjustable by means of the switches T between 0 and $-E.2.R_{fR}$. If a resistor R is arranged between 12 and the reference supply -E, the output voltage of the amplifier will be adjustable from $+E.R_{f/R}$ *via* zero to $- E.R_{f/R}$. In the last-mentioned case, the zero point on the output 15 can be shifted to a negative value by providing a resistor Rx and to a positive value by providing a resistor Ry. If the resulting analog signal is required to be available *via* a capacitor, a capacitor 16 is included. The alternating signal is then available on output 17.

The generator Section A in Figure 3 is arranged between the digital inputs, designated $2^{n-1}$, $2^{n-2}$ to $2^1$, $2^0$, of the digital-to-analog converter and the digital inputs $D_1$, $D_2$ to $D_n$ of the converter section B. As is apparent from the Figure, many inputs ($2^n$) may be coupled to the corresponding inputs Dn-m. By means of two "4 bit full adders" FA1 and FA2, for example Signetics type 54/7843 or 54LS/74LS83A, the offset can be set with an accuracy of 8 bits. Generally this accuracy is not required and RA2 may even be dispensed with when an offset accurate to 0001 suffices. The desired offset can be set by means of potentials representing the digital values 0 and 1. By way of example the offset is set to 0000.0101 in the Figure. This corresponds to substantially 2% of the range. For subtracting a number rather than adding it to a slightly more intricate circuit is required. However, the techniques are similar to those applied by means of the elements FA1 and FA2.

It is alternatively possible to employ shift registers for the generator of the digital number, provided that a serial converter is used, instead of the parallel converter illustrated in Figure 3.

## Claims

1. A digital-to-analog converter for bipolar signals, in which the value of the most significant bit changing when the signal passes through the zero level, which converter comprises $n$ inputs for $n$ bits to be converted, at least $n$ switches, which are coupled to the $n$ inputs and which switch analog reference quantities, which together determine the analog value, which is available on an output of the converter, and means for reducing the influence of switching transients on the analog value when the bits change in value, characterized in that the said means comprise a generator, which generates a digital number and which is arranged between the said inputs and the switches and thereby provides an internal digital offset.

2. A digital-to-analog converter is claimed in Claim 1, characterized in that an analog compensation source is coupled to the output in order to compensate for the effect on the analog value of the digital offset.

3. A digital-to-analog converter as claimed in Claim 1 or 2, characterized in that the generator comprises an adder, of which a number of inputs are connected to an equal number of said $n$ inputs corresponding to the most significant bits, of which an equal number of further inputs are connected to points carrying potentials which together correspond to the digital number, and of which an equal number of outputs are coupled to control inputs of those switches which switch the most significant reference quantities.

## Revendications

1. Convertisseur NA pour des signaux bipolaires, dans lequel la valeur du bit le plus significatif varie lorsque le signal passe par le niveau zéro, convertisseur qui présente $n$ entrées pour $n$ bits à convertir, au moins $n$ commutateurs, qui sont couplés aux $n$ entrées et qui assurent la commutation de grandeurs de référence analogiques déterminant ensemble la valeur analogique pouvant être prélevée sur une sortie du convertisseur, et des moyens servant à réduire l'influence de transitoires de commutation sur la valeur analogique lorsque les bits changent de valeur, caractérisé en ce que lesdites moyens comportent un générateur pouvant engendrer une valeur numérique et disposé entre lesdites entrées et les commutateurs tout en fournissant un décalage numérique interne.

2. Convertisseur NA selon la revendication 1, caractérisé en ce qu'une source de compensation analogique est couplée à la sortie afin de compenser l'effet sur la valeur analogique du décalage numérique.

3. Convertisseur NA selon la revendication 1 ou 2, caractérisé en ce que le générateur comporte un additionneur, dont un nombre d'entrées est connecté à un nombre égal desdites $n$ entrées correspondant aux bits les plus significatifs, dont un nombre égal d'autres entrées est connecté à des points présentant des potentiels, qui corespondent ensemble à la valeur numérique, et dont un nombre égal de sorties est couplé à des entrées de commande de ces commutateurs, qui assurent la commutation des quantités de référence les plus significatives.

## Patentansprüche

1. Digital-Analog-Wandler für bipolare Signale, bei dem das Bit höchster Wertigkeit beim Nulldurchgang des Signals den Wert ändert, mit n Eingängen für n umzusetzende Bits, weiter mit mindestens n Schaltern, die an die n Eingänge angeschlossen sind und analoge Referensgrössen schalten, die gemeinsam den analogen Wert bestimmen, der an einem Ausgang des Wandlers abgreifbar ist, und mit Mitteln zum Ungerdrücken des Einflusses von Schaltspitzen auf den Analogwert, wenn die Bits ihren Wert ändern, dadurch gekennzeichnet, dass die erwähnten Mittel einen Generator enthalten, der eine digitale Zahl erzeugt, zwischen den erwähnten Eingängen und den Schaltern angeordnet ist und damit einen inneren digitalen Offset erzeugt.

2. Digital-Analog-Wandler nach Anspruch 1, dadurch gekennzeichnet, dass eine analoge Ausgleichsquelle mit dem Ausgang zum Ausgleichen des Effekts des digitalen Offsets in dem analogen Wert verbunden ist.

3. Digital-Analog-Wandler nach Anspruch 1 oder 2, dadurch gekennzeichnet, dass der Generator einen Addierer enthält, von dem eine Anzahl von Eingängen mit einer gleichen Anzahl von n Eingängen des Wandlers entsprechend den Bits höchster Wertigkeit verbunden ist, von dem eine gleiche Anzahl weiterer Eingänge mit Potentialpunkten verbunden ist, die der digitalen Zahl entsprechen und von dem eine gleiche Anzahl von Ausgängen mit Steueringängen jener Schalter verbunden ist, die die Referenzgrössen höchster Wertigkeit schalten.

FIG.1

FIG.2

1

FIG.3